(19) **Europäisches Patentamt**

**European Patent Office**

**Office européen des brevets**

(11) **EP 1 127 287 B1**

(12) **EUROPÄISCHE PATENTSCHRIFT**

(45) Veröffentlichungstag und Bekanntmachung des Hinweises auf die Patenterteilung:
**17.07.2002 Patentblatt 2002/29**

(51) Int Cl.[7]: **G02B 7/00**, G02B 7/02, G12B 7/00

(21) Anmeldenummer: **99953953.9**

(22) Anmeldetag: **29.10.1999**

(86) Internationale Anmeldenummer:
**PCT/EP99/08207**

(87) Internationale Veröffentlichungsnummer:
**WO 00/28367 (18.05.2000 Gazette 2000/20)**

(54) **EINRICHTUNG ZUR THERMISCH STABILEN HALTERUNG EINES MINIATURISIERTEN BAUTEILS**

DEVICE FOR THERMALLY, STABLY SUPPORTING A MINIATURISED COMPONENT

DISPOSITIF POUR LA FIXATION STABLE THERMIQUEMENT D'UN COMPOSANT MINIATURISE

(84) Benannte Vertragsstaaten:
**CH DE FI FR GB LI NL**

(30) Priorität: **05.11.1998 DE 19850888**

(43) Veröffentlichungstag der Anmeldung:
**29.08.2001 Patentblatt 2001/35**

(73) Patentinhaber:
• **Leica Geosystems AG
9435 Heerbrugg (CH)**
• **MTA Automation AG
CH-2555 Brügg (CH)**

(72) Erfinder:
• **REMY DE GRAFFENRIED, Christian
CH-1814 La Tour-de-Peilz (CH)**
• **SCUSSAT, Marco, Antonio
I-20126 Milano (IT)**

(74) Vertreter: **Kaminski, Susanne et al
Büchel, Kaminski & Partner
Austrasse 79
9490 Vaduz (LI)**

(56) Entgegenhaltungen:
EP-A- 0 298 058          EP-A- 0 620 464
DE-A- 3 634 196          DE-A- 19 533 426
FR-A- 2 534 663          US-A- 4 116 537
US-A- 4 268 123          US-A- 5 781 355

• KRYSZCZYNSKI T ET AL: "MATERIAL PROBLEM IN ATHERMALIZATION OF OPTICAL SYSTEMS" OPTICAL ENGINEERING,US,SOC. OF PHOTO-OPTICAL INSTRUMENTATION ENGINEERS. BELLINGHAM, Bd. 36, Nr. 6, 1. Juni 1997 (1997-06-01), Seite 1596-1601 XP000693504 ISSN: 0091-3286

**Beschreibung**

Die Erfindung betrifft eine Einrichtung zur Halterung eines miniaturisierten - insbesondere eines elektronischen oder optischen Bauteils - gemäß dem Oberbegriff des Anspruches 1.

In der DE 195 33 426 A ist ein mechanisches Befestigungssystem für modulare, bevorzugt in einem Gehäuse gefaßte, mikrooptische Elemente auf einer Grundplatte zur Herstellung eines optischen bzw. optoelektronischen Layouts beschrieben. Eine Halterung ist mit einer mittigen Plattform ausgebildet, die einen Einzelmodul trägt. An der Plattform sind bevorzugt über Scharniere mindestens drei Beine angelenkt, die an der Grundplatte z.B. durch Laserpunktschweißen oder Löten befestigt werden. Dieses bekannte Befestigungssystem erlaubt, optische Bauteile schock- und vibrationsstabil zu halten.

Der Erfindung liegt die Aufgabe zugrunde, eine Einrichtung zur Halterung eines Bauteils gemäß dem Oberbegriff des Anspruches 1 derart weiterzubilden, daß der Einfluß von Temperaturänderungen auf die Position des Bauteils möglichst weitgehend ausgeglichen werden kann.

Diese Aufgabe wird erfindungsgemäß durch die Merkmale des kennzeichnenden Teils des Anspruches 1 gelöst.

Vorteilhafte Weiterbildungen des Erfindungsgegenstandes sind in den Unteransprüchen angegeben:

Grundgedanken erfinderischer Einrichtungen und Verfahren sind im folgenden angegeben.

Bei einem Verfahren zur Oberflächenmontage dreidimensionaler, miniaturisierter, optischer Einrichtungen, das für einen automatischen Fließbandzusammenbau mit sechs Freiheitsgräden auf einer Trägerplatte von optischen, elektronischen und miniaturisierten mechanischen Bauteile durch ein flußfreies und genaues Laserlötverfahren geeignet ist, sind einige Abänderungen an den Halteteilen für die "TRIMO SMD"-Technik (three-dimensional miniaturized surface mounted devices = Oberflächenmontage dreidimensionaler, miniaturisierter, optischer Einrichtungen) vorgenommen worden, um die Ergebnisse zu verbessern, die mit dieser Verfahrenstechnik erhalten werden können.

Die Halteeinrichtung ist nun aus wenigstens zwei Teilen zusammengesetzt, die durch eine geringe Bearbeitungsgenauigkeit charakterisiert sind: ein normales Halteteil, das durch Formstanzen beispielsweise eines 0,1 mm dicken Blechs hergestellt wird, und die Halterung für das optische Element. Die Form und die Abmessungen der Halteteile sind üblich und insbesondere so konstruiert worden, damit sie verschiedene optische Halterungsteile aufnehmen können. Das normale Halteteil ist aus einer Kugelschalenbasis, die mit einer dünnen Zinnschicht bedeckt ist, und aus zwei Metallappen gebildet, die senkrecht zu der Basis des Halteteils angeordnet sind. Diese Lappen sind äußerst zweckmäßig, da sie die Befestigung des Halteteils an dem optischen Halterungsteil ermöglichen, und die es darüber hinaus auch ermöglichen, daß das Halteteil leicht von einem Roboter ergriffen werden kann.

Das optische Element wird normalerweise grob innerhalb des Halterungsteils positioniert (± 0,2 mm) und durch Kleben oder eine mechanische Kraft gehalten, die allgemein durch eine Feder aufgebracht wird.

Jedes Halterungsteil wird besonders bearbeitet, um ein optisches Element, eine Linse, eine optische Faser oder eine Laserdiode aufzunehmen. Der Abstand zwischen der Brennachse und der Basis des Halteteils kann genau eingestellt werden, indem die Position des optischen Halterungsteils innerhalb des Halteteils verschoben wird. Sie können ohne weiteres auf unterschiedliche Weise im voraus zusammengebaut werden, wie durch Laserpunktschweißen, Kleben oder elektrisches Widerstandspunktschweißen. Sobald der Zusammenbau abgeschlossen ist, kann das Halteteil an einer Trägerplatte befestigt werden.

Da die zwei Teile, die die Halteeinrichtung bilden, vollständig unabhängig sind, können sie aus unterschiedlichen Werkstoffen hergestellt werden. Eine Beschränkung ist, daß das normale Halteteil aus einem Metall hergestellt werden muß, das durch Zinn benetzt werden kann, anderenfalls muß eine mit Zinn benetzbare Schicht auf der kugelförmigen Basis des Halteteils aufgebracht werden. Diese Schicht, die auf unterschiedliche Weise hergestellt werden kann, wie z.B. durch physikalische Dampfabscheidung oder galvanische Wirkung, wird - es sei denn, sie ist sehr dick - schnell durch das flüssige Zinn angegriffen und neigt dazu, sich aufzulösen. Nach kurzer Zeit ist es nicht mehr möglich, eine ausreichende Garantie zu geben, daß sie eine widerstandsfähige und geeignete Grenzschicht zwischen dem Halteteil und der Trägerplatte ist. Das Abscheiden einer mit Zinn benetzbaren Schicht verbessert somit die Befestigungsbedingungen nicht und verbessert nicht die Kosten und die Komplexität des Halteteils.

Der Werkstoff zur Herstellung des Halteteils muß eine ausreichende Verformbarkeit aufweisen, um das Formstanzverfahren auszuhalten, aber gleichzeitig darf es, um eine starre Befestigung zu gewährleisten, nicht zu schwach oder zu weich sein. Normalerweise wird das Halteteil aus CuBe (Kupfer-Beryllium), Nickel, Invar oder Kupfer hergestellt.

Das optische Halterungsteil wird normalerweise durch Bearbeitung eines 1 mm dicken Bleches aus entweder CuBe oder Invar oder rostfreiem Stahl oder $Al_2O_3$ hergestellt. Die Auswahl des Werkstoffs hängt davon ab, wie die zwei Teile zusammengebaut werden sollen.

Da das Halteteil unter Verwendung eines 0,1 mm dicken Metallblechs hergestellt wird, ist es durch einen hohen Wärmewiderstand gekennzeichnet, der es ermöglicht, daß das optische Halterungsteil wärmemäßig isoliert ist. Dies verhindert, daß das optische Halterungsteil während der Laserbestrahlung beschädigt wird. Der Wärmefluß, der die Basis des Halteteils erreicht, begegnet großen Schwierigkeiten, entlang des Halteteils aufgrund seines hohen Wärmewiderstands abgeleitet zu werden. Nur eine geringe Wärmemenge kann den optischen Halterungsteil erreichen, wodurch keine gefährliche Erwärmung hervorgerufen wird, und diese geringe Erwärmung daher vernachlässigt werden kann.

Die Tatsache, daß während des Lötverfahrens die durch den Laser gelieferte Energie in einem kleinen Teil des Halteteils begrenzt bleibt, ermöglicht es, eine Verschwendung von Energie zu begrenzen, und eine weniger leistungsstarke Laserstation zu verwenden.

Wenn das Halteteil ein aktives Element enthält, das Wärme erzeugt, wie eine Laserdiode oder ein elektrischer Widerstand, stellt der hohe Wärmewiderstand des Halteteils sogar einen Nachteil dar. Das aktive Element würde, ohne die von ihm erzeugte Wärme abzuleiten, aufgrund seiner fortlaufenden Erwärmung unvermeidlich zum Versagen gebracht werden. Die kleinen Abmessungen gestatten nicht, das Halteteil mit einem Strahler (Wärmesenke) zu versehen. Die Verwendung der Trägerplatte als ein Strahler, der die meiste erzeugte Wärme ableiten kann, stellt eine ansprechende und mögliche Lösung dar. Sie kann nur erreicht werden, wenn die Trägerplatte unter Verwendung eines Werkstoffes hoher Wärmeleitfähigkeit hergestellt wird, und auch nur, wenn die Wärme zu der Trägerplatte fließen kann. Dieser zweite Gesichtspunkt auferlegt eine Verringerung des Wärmewiderstands des Halteteils. In dem Fall, daß eine große Wärmemenge abgeleitet werden muß, muß eine Trägerplatte aus Saphir verwendet werden (Wärmeleitfähigkeit: 41 $Wm^{-1}K^{-1}$). In allen anderen Fällen ist es vorteilhafter, die Trägerplatte aus Werkstoffen herzustellen, die eine viel geringere Wärmeleitfähigkeit haben, wie Pyrex, $Al_2O_3$, Zerodor, Quarz und Float- Glas. Das Float-Glas ist am wenigstens geeignet, weil es während des Lötverfahrens brechen kann, da es keine Wärmeschocks aushält.

Das Lötverfahren, das auf einer Trägerplatte aus Saphir durchgeführt wird, ist tatsächlich wegen seiner hohen Wärmeleitfähigkeit äußerst problematisch. Die Energiemenge, die von dem Laser ausgesandt werden muß, um die Zinnschicht zum Schmelzen zu bringen, ist viel größer als die Energie, die bei einer Trägerplatte mit einer niedrigeren Wärmeleitfähigkeit verlangt würde. Das bestehende Verhältnis zwischen den Energiewerten, die für eine Trägerplatte aus Saphir und für irgendeine andere Trägerplatte verlangt werden, kann bis zum Zweifachen gehen. Die Notwendigkeit einer viel leistungsstärkeren Laserlötstation bedingt infolgedessen eine größere Investition für den Laserkauf und auch höhere Benutzungskosten.

Wenn die Trägerplatte als ein Strahler wirkt, sollte das Halteteil die Wärme, die durch das aktive Element erzeugt wird, auf sie übertragen können. Dies kann nicht wirklich erreicht werden, wenn das Halteteil durch einen hohen Wärmewiderstand gekennzeichnet ist. Gleichzeitig würde, wenn das Halteteil durch einen geringen eigenen Wärmewiderstand gekennzeichnet wäre, die während des Lötverfahrens durch den Laser erzeugte Wärme schnell das optische Element erreichen und es dann beschädigen. Der Wärmewiderstand des Halteteils muß sich während des Verfahrens ändern: ein hoher Widerstand während des Lötverfahrens und ein niedriger Widerstand, nachdem die Befestigung herstellt worden ist. Dies kann erreicht werden, indem die Kugelschale mit einem geeigneten wärmeleitenden Material gefüllt wird.

Wenn 50°C als die maximale Temperatur angenommen wird, die von irgendeinem optischen Element nicht überschritten werden soll, können 0,5 W durch ein auf einer Trägerplatte aus Saphir befestigtes Halteteil abgeleitet werden, dessen Kugelschale nicht gefüllt ist. Die Energie, die ohne weiteres abgeleitet werden kann, wird zu 0,75 W in dem Fall, wenn die Kugelschale mit einem geeigneten wärmeleitenden Material gefüllt ist.

$Al_2O_3$ kann verwendet werden, um daraus eine Trägerplatte herzustellen. Ein dünnes Blech aus $Al_2O_3$ ermöglicht den Durchgang des Laserstrahls für den Lötvorgang. $Al_2O_3$ hat gute mechanische Eigenschaften und sein Wärmeleitfähigkeitskoeffizient ist kleiner als der Wärmeleitfähigkeitskoeffizient von Saphir, ist aber gleichzeitig viel größer als der jeweilige Wärmeleitfähigkeitskoeffizient der anderen Werkstoffe, die zur Herstellung von Trägerplatten verwendet werden (Wärmeleitfähigkeit: 24 $Wm^{-1}K^{-1}$). Eine Trägerplatte aus $Al_2O_3$ kann sich wie ein Strahler verhalten, ohne die Schwierigkeiten einer Trägerplatte aus Saphir zu zweigen.

Das Halteteil hat eine kugelförmige Basis erhalten, weil dieses die ideale Form ist, eine gute Symmetrie des Lötmittels zu gewährleisten. Eine ausgeglichene Verteilung der mechanischen Größen vermeidet Schrumpfen, das während der Zinnerstarrung stattfindet und das Halteteil relativ zu der Trägerplatte dreht. Während der Ausrichtphase werden trotz der Tatsache, daß sich das Halteteil um seine optische Achse drehen kann, keine Änderungen an den Randbedingungen eingeführt, die an den Grenzflächen zwischen der Halteteilbasis und der Trägerplatte vorhanden sind.

Wenn das Halteteil mit einer flachen Basis versehen wäre, würde in dem Fall, wenn das Halteteil während der Ausrichtphase (um seine optische Achse) mit einem Winkel Y gedreht worden wäre, die Zinnerstarrung mit einer zusätzlichen Drehung β folgen, die von Y und auch den Eigenschaften des Lötmaterials abhängt.

β hat eine zu Y entgegengesetzte Richtung. Die vertikale Differenz zwischen den Koordinaten A und B relativ zu der Trägerplatte, nachdem die Drehung angewendet wurde, ist:

$$Dy = AB \cdot TgY$$

Eine Lötzinnlegierung, deren Schmelzpunkt 179°C ist, wurde verwendet. Ihr Wärmeausdehnungskoeffzient ist $24 \cdot 10^{-6}$ K$^{-1}$. Bei diesem Beispiel wurde eine Umgebungstemperatur von 20°C angenommen. Nach der Erstarrung wird die vertikale Differenz zwischen A und B zu:

$$Dy + 24 \cdot 10^{-6} \cdot Dy \cdot 159°.$$

Die zusätzliche Drehung ist gleich:

$$\beta = Y - Tg^{-1}\left(\frac{Dy + 24 \cdot 10 \cdot Dy \cdot 159°}{AB}\right).$$

Wenn eine Drehung von Y um 5° betrachtet wird und wenn AB = 2 mm ist, wäre die zusätzliche Drehung β gleich 19 mrad.

Wenn eine Drehung von Y um 2° betrachtet wird und wenn AB = 2 mm ist, wäre die zusätzliche Drehung β gleich 7,6 mrad.

Wenn eine Drehung von Y um 10° betrachtet wird und wenn AB = 2 mm ist, wäre die zusätzliche Drehung β gleich 37,4 mrad.

Die Tatsache, eine dünne Zinnschicht auf der Halteteilbasis abzusetzen, verschlechtert nicht merklich die Möglichkeit, ihre Winkelposition um ihre optische Achse herum anzuordnen, ohne daß die Basis mit der Trägerplatte in Berührung kommt. Eine Tabelle ist hierfür vorgesehen, in der für jeden vertikalen Zwischenraum zwischen der Halteteilbasis und der Trägerplatte die entsprechende maximale Drehung angegeben ist, der das Halteteil unterzogen werden kann, ohne daß es mit der Trägerplatte in Berührung kommt:

Zwischenraum = 0,1 mm,       zulässiger Winkel = 12,8°:
Zwischenraum = 0,2 mm,       zulässiger Winkel = 31,5°.

Bei einem Zwischenraum > 0,3 mm ist eine vollständige Drehung erlaubt.

Die kugelförmige Basis des Halteteils gestattet es, die besten Ergebnisse hinsichtlich der Befestigungsgenauigkeit zu erzielen. Die Endgenauigkeit hängt direkt von der Wiederholbarkeit des Schrumpfens ab. Eine gute Befestigungsgenauigkeit kann nur erhalten werden, wenn das Schrumpfen im voraus ausgeglichen worden ist. Gegenwärtig ist mit dieser Technik eine Wiederholbarkeit des vertikalen Schrumpfens in der Größenordnung von einigen Mikron gemessen worden, und wenn ein Ausgleich vorgenommen wird, kann eine Wiederholbarkeit der Gesamtbefestigung von mehr oder weniger als 0,5 μm erreicht werden.

Da das Lötverfahren durch eine Roboter-Zusammenbaustation durchgeführt wird, wird die Befestigungsgenauigkeit durch den Greifer beeinflußt, der an dem Roboter angebracht ist. Der Greifer muß das Halteteil erfassen, es relativ zu äußeren Bezugspunkten positionieren, es während der Laserbestrahlung in seiner Lage halten und es freigeben, nachdem die Befestigung hergestellt worden ist. Aufgrund der kleinen Abmessungen des Halteteils (2 x 2 x 3 mm) ist es schwierig, dieses gleichbleibend zu ergreifen. Bei der Konstruktion des Greifers muß eine grundsätzliche Wahl getroffen werden. Eine Lösung liegt in der Tatsache, einen Greifer zu konstruieren, der unendlich starr ist und sich selbst der Metallschrumpfungskraft widersetzt. Eine andere Lösung kann sein, einen Greifer mit einer gutdefinierten elastischen Nachgiebigkeit in der vertikalen Richtung herzustellen. In diesem Fall würde die Metallschrumpfung nicht behindert werden, sondern wäre vielmehr entlang einer genauen Raumrichtung gestattet. Sie kann durch eine lineare Führung mit flexiblen Drehbefestigungen erreicht werden.

Die zweite Lösung wird gegenüber der ersten aus den folgenden Gründen bevorzugt:

Eine Konstruktion, die sich als nichtverformbar gegenüber der Kraft verhalten kann, die durch die Schrumpfung des Zinnmetalls erzeugt wird, wäre zu robust, als daß sie für eine Roboterstation hoher Genauigkeit geeignet wäre. Die Metallschrumpfung erzeugt eine mechanische Belastung, die größer als die Grenzzugfestigkeit des Lötmittels sein kann, und die dann dazu führen würde, daß die Befestigung versagt.

Ein Beispiel, das einen vereinfachten typischen Fall darstellt, wird hier nun beschrieben. Die Zinnschicht ist 1 mm dick und ihre Wärmeschrumpfung ist gleich 4 μm. Dieser Wert entspricht einem Durchschnitt von Werten, die durch Versuche erhalten wurden. In dem Fall, daß der Greifer nicht verformbar ist, würde die Lötung reagieren und eine Spannung erzeugen, die dazu neigen würde, die Trägerplatte eine Strecke in Richtung des Greifers zu ziehen. Die Bewegungsgröße der Strecke wäre: Dy = 1004 - 1000 mm.

$$\varepsilon = \frac{\Delta l}{l} = \frac{1004 - 1000}{1000} = 0,004$$

$$\sigma = \varepsilon \cdot 7,2 \cdot 10^4 = 288 \ N/mm^2$$

Da die auf das Zinn ausgeübte Belastung in diesem Fall viel höher als seine Bruchgrenze ist, würde sich unvermeidlich ein Fehler ergeben.

Die Verwendung einer elastischen Konstruktion für den Greifer verschlechtert die endgültige Befestigungsgenauigkeit nicht, wenn man annimmt, daß die Greiferkonstruktion ausreichend starr ist, um während der Bestrahlungsdauer das Halteteil in einer festen Position zu halten. Die mechanischen Spannungen treten tatsächlich nur auf, wenn die Zinnschicht ihre Phase ändert und erneut in den festen Zustand zurückkehrt. Von diesem Zeitpunkt an beteiligt sich die Verformbarkeit des Greifers.

Die notwendige Greifkraft kann auf unterschiedliche Weise bereitgestellt werden, wobei es aber wegen der kleinen Abmessung des Halteteils schwierig ist, eine Kraft mit ausreichender Vorsicht auszuüben. Aufgrund der erhöhten Befestigungsgenauigkeit, die verlangt wird, muß das Halteteil von dem Greifer freigegeben werden, ohne daß seine Position beeinträchtigt wird. Die meisten Lösungen, bei denen die Greifkraft durch eine mechanische Wirkung erzeugt wird, müssen unberücksichtigt bleiben, weil sie während der Freigabephase die Befestigungsgenauigkeit beeinträchtigen können.

Als geeignetste Lösung hat sich ein Greifer erwiesen, dessen Kraft durch einen Magneten erzeugt wird. Ein kleiner Magnet kann sich innerhalb eines Rohres verschieben, das aus einem nichtmagnetischen Material hergestellt ist. Eine kleine Weicheisenscheibe ist auf der Oberseite des Halteteils angeklebt. Das Rohr wird vertikal gehalten, und das Halteteil, das ergriffen werden soll, wird gegen die Bodenseite des Rohrs gedrückt. Die Abmessung der Scheibe ist etwas größer als die Außenabmessung des Rohrs. Während der Greifphase wird der Magnet nahe zu dem Ende des Rohrs gedrückt. In dieser Position kann er eine ausreichende Anziehungskraft ausüben, die die Weicheisenscheibe fortwährend in Berührung mit dem Ende des Rohres halten kann. Die Verwendung irgendeines Positionierungsstifts ermöglicht es, eine ausreichende Greifgenauigkeit zu gewährleisten. Sobald die Befestigung hergestellt worden ist, kann das Halteteil freigegeben werden, ohne irgendeine zusätzliche Belastung einzubringen. Der Magnet wird entlang dem Rohr hochgezogen, während die Weicheisenscheibe weiterhin mit dem Rohrende in Berührung ist. Die Kraft, die der Magnet während seiner Bewegung ausübt, kann die Scheibe nicht beeinflussen, weil sie bereits an ihrem Endpunkt ist. Während der Entfernung des Magnets wird die von dem Magnet ausgeübte Kraft schwächer und schwächer, und nach einiger Zeit kann sie vernachlässigt werden. Das Halteteil ist zu diesem Zeitpunkt vollständig frei, und während der Freigabephase wird keine mechanische Belastung ausgeübt.

Die Einrichtung zum Befestigen bzw. Halten kann, da sie aus zwei getrennten Teilen zusammengesetzt ist, ihre Wärmeausdehnung ausgleichen. Dieser Gesichtspunkt kann besonders zweckmäßig in dem Fall sein, daß zu einem bestimmten Zeitpunkt auf der Trägerplatte ein Temperaturgradient vorhanden ist. Dies kann in dem Fall auftreten, wenn ein Halterungsteil ein aktives wärmeerzeugendes Element hält, wie beispielsweise eine Laserdiode.

Das Halteteil und das optische Halterungsteil können im voraus zusammengebaut werden, wobei ein einfaches Paar Laserpunktschweißungen verwendet wird, und jeder Schweißpunkt am oberen Ende der Lappen des Halteteils vorgesehen wird. Auf diese Weise kann sich das optische Halterungsteil aufgrund des Temperaturgradienten abwärts in bezug auf das Halteteil ausdehnen, weil er nur mit seinem oberen Abschnitt verbunden ist. Gleichzeitig dehnt sich das Halteteil, das das optische Halterungsteil aufweist, nach oben relativ zu seiner Basis bzw. zu der Trägerplatte aus. Wenn die zwei Ausdehnungen dieselbe Größe erreicht haben, ist ihre Gesamtwirkung in bezug auf die Basis des Halteteils gleich Null, und dies bedeutet, daß die Wärmeausdehnung in dieser Hinsicht kompensiert worden ist. Dieser Ausgleich kann entweder erreicht werden, indem ein geeignetes Paar Werkstoffe - zur Herstellung des Halteteils und des optischen Halterungsteils - verbunden wird, und auch, indem die Laserschweißpunkte, die verwendet werden, um das optische Halterungsteil an dem Halteteil zu befestigen, an der richtigen Position angeordnet werden.

Jedoch kann kein vollständiger thermischer Ausgleich in bezug auf die Trägerplatte hergestellt werden, weil dies auch den Ausgleich der Wärmeausdehnung der Zinnlötung verlangen würde. Obgleich ein Ausgleich der Zinnschicht durch die Systemgeometrie und durch die physikalischen Eigenschaften der verwendeten Werkstoffe erlaubt würde, kann er nicht erreicht werden. Der vorhandene Zwischenraum zwischen der Halteteilbasis und der Trägerplatte kann tatsächlich nicht im voraus definiert werden. Er wird tatsächlich nur während der Ausrichtungsphase definiert, und dann ändert sich sein Wert für jedes der Elemente. Das optische Halterungsteil und das Halteteil werden im voraus zusammengebaut, bevor das Halteteil an der Trägerplatte befestigt wird. Es ist dann nicht möglich, im voraus eine Größe auszugleichen, deren Wert unbekannt ist. Obgleich die Wärmeausdehnung nicht vollständig zwischen Halterungsteil und Trägerplatte ausgeglichen werden kann, kann ihr Einfluß zumindest beschränkt werden. In den meisten Fällen wird jedenfalls die Trägerplatte vollständig dem gleichen Wärmegradienten ausgesetzt. Die Elemente dehnen sich dann mit der gleichen Größe aus und bleiben trotz der Ausdehnung ausgerichtet.

Einige Beispiele stellen die Durchführbarkeit dieses Prinzips dar. Wir nehmen die Verwendung eines Lötmittels aus der Legierung mit der Zusammensetzung: 62Sn 36Pb 2Ag an, deren Wärmeausdehnungskoeffizient $24 \cdot 10^{-6} K^{-1}$ ist.

Das Halteteil kann durch Formstanzen eines 0,1 mm dicken Invar-Bleches hergestellt werden, dessen Wärmeausdehnungskoeffizient $2 \cdot 10^{-6}K^{-1}$ ist. Das optische Halterungsteil wird aus Silber hergestellt, dessen Wärmeausdehnungskoeffizient $19 \cdot 10^{-6}K^{-1}$ ist. Es wurde angenommen, daß das Lötmittel einen Zwischenraum von 0,2 mm zur Befestigung füllen muß. Der Zusammenbau des Halteteils und des optischen Halterungsteils ist so hergestellt worden, daß ein vollständiger Wärmeausdehnungsausgleich erreicht wurde. Es wurde ein Betriebstemperatur-Gradient von 50°C angenommen. Die Gesamtausdehnung ist das Ergebnis der Differenz zwischen der Aufwärts-Ausdehnung und der Abwärts-Ausdehnung. Die Aufwärts-Ausdehnung ist gleich der Ausdehnung des Halteteils plus der Ausdehnung des Lötmittels, während die Abwärts-Ausdehnung nur durch die Ausdehnung des optischen Halterungsteils gebildet ist. Die Gesamtausdehnung kann durch die folgende Gleichung dargestellt werden, in der X als der gegenseitige Abstand angenommen worden ist, der zwischen dem Laserfleck und der optischen Achse gelassen werden muß, um eine Gesamtausdehnung von Null zu erhalten:

$$Dy = Dy_{abwärts} - Dy_{aufwärts}$$

$$= Dy_{Halteteil} + Dy_{Lötmittel} - Dy_{optisches\ Halterungsteil} = 0$$

$$Dy = 0,2 \cdot 24 \cdot 50 \cdot 10^{-6} + 1,8 \cdot 2 \cdot 50 \cdot 10^{-6} + X \cdot 2 \cdot 50 \cdot 10^{-6} - X \cdot 19 \cdot 50 \cdot 10^{-6} = 0$$

$$Dy = 0,00042 + 0,00105 \cdot X = 0$$

$$X = 0,4\ mm.$$

In diesem besonderen Fall müssen, um irgendwelche Wärmeausdehnung aufzuheben, die Laserschweißpunkte 0,4 mm oberhalb der optischen Achse angeordnet werden. Die Abwärts-Ausdehnung des optischen Halterungsteils ist tatsächlich gleich der Aufwärts-Ausdehnung des gesamten Halteteils plus der Ausdehnung des Lötmittels. Dieses Beispiel zeigt, daß es im Prinzip wirksam möglich ist, einen vollständigen Ausgleich des Systems durchzuführen. Das einzige Problem ist, daß der Wert des Zwischenraums zwischen der Halteteilbasis und der Trägerplatte, der in diesem Fall gleich 0,2 mm ist, nicht im voraus definiert werden kann.

Normalerweise wird während der Zusammenbauphase die Ausdehnung des Lötmittels entweder vernachlässigt oder es wird ein Durchschnittswert in Betracht gezogen. Es werden nun einige Beispiele dargestellt, bei denen die Ausdehnung des Lötmittels vernachlässigt worden ist.

Es wird der Fall betrachtet, bei dem das Halteteil aus Invar mit einem Wärmeausdehnungkoeffizienten von $2 \cdot 10^{-6}K^{-1}$ hergestellt wurde, während das optische Halterungsteil aus Kupfer-Beryllium mit einem Wärmeausdehnungskoeffizienten von $9 \cdot 10^{-6}K^{-1}$ hergestellt wurde. Auch in diesem Fall kann die vertikale Ausdehnung der Einrichtung durch die folgende Gleichung wiedergegeben werden:

$$Dy = Dy_{Halteteil} - Dy_{optisches\ Halterungsteil} = 0$$

$$Dy = 1,8 \cdot 2 \cdot 50 \cdot 10^{-6} + X \cdot 2 \cdot 50 \cdot 10^{-6} - X \cdot 9 \cdot 50 \cdot 10^{-6} = 0$$

$$Dy = 0,00018 + 0,00035 \cdot X = 0$$

$$X = 0,51\ mm.$$

Ein Ausgleich der Wärmeausdehnung des Halteteils würde verlangen, das Paar Laserpunktschweißungen 0,51 mm oberhalb der optischen Achse des Elements anzuordnen.

Bei einem anderen Fall wurde die Halteeinrichtung aus Kupfer-Beryllium hergestelit, während der optische Halterungsteil aus Kupfer mit einem Wärmeausdehnungskoeffizienten von $17 \cdot 10^{-6}K^{-1}$ hergestellt wurde. Die Ausdehnung des Halteteils ist:

$$3•50•9•10^{-6} = 0{,}00135 \text{ mm}.$$

Die Ausdehnung des optischen Halterungsteils ist: $X•50•17•10^{-6}$
Somit ergibt sich:

$$X = \frac{0{,}00135}{0{,}00085} = 1{,}59 \text{ mm}.$$

In diesem besonderen Fall kann die Wärmeausdehnung nicht vollständig wegen der Beschränkungen der optischen Halterungsteil-Geometrie ausgeglichen werden.

Der maximal zulässige Abstand zwischen der optischen Achse und dem Laserschweißpunkt darf nicht größer als 1 mm sein. Da das optische Halterungsteil eine Höhe von 2 mm aufweist, darf ein Laserschweißpunkt nicht weiter als 1 mm von der horizontalen Mittellinie des optischen Halterungsteils entfernt sein.

In diesem Fall ist es, obgleich ein vollständiger Ausgleich nicht erhalten werden kann, möglich, einen teilweisen Ausgleich durchzuführen, um die Befestigungsgenauigkeit zu verbessern. Ohne irgendeinen Ausgleich wäre die Wärmeschrumpfung des Halteteils 0,00135 mm. Im Gegensatz dazu kann, wenn der maximale zulässige Ausgleich durchgeführt wird, das Ergebnis verringert werden auf:

Ausdehnung des Halteteils - Ausdehnung des optischen

Halterungsteils = 0,00135 - 0,00085 = 0,0005 mm.

Die bisher vorgeschlagenen Lösungen sind nicht vollständig festgelegt, sondern es können viele Abänderungen ausgeführt werden, um die Technik an die Anforderungen unterschiedlicher Anwendungen anzupassen. Beispielsweise kann als Trägerplatte eine Siliciumplatte verwendet werden, um sie kompatibel zu machen, und dann unmittelbar die optische Auslegung mit Mikroelektronikmodulen zu integrieren, die durch Silicium hergestellt werden. Da Silicium eine gute Durchlässigkeit für Laserlicht mit einer Wellenlänge zwischen ca. 1,4 μm und 15 μm aufweist, kann ein $CO_2$-Laserstrahl verwendet werden, um die Befestigung durchzuführen.

Es ist möglich, daß derselbe hybride Siliciummodul die optische Auslegung enthält, die mit der "TRIMO" - (dreidimensionalen miniaturisierten optischen) Technik und einem "SMD" - (oberfiächenmontierte Einrichtung) Elektronikmodul hergestellt wird. Diese Lösung würde die Probleme aufgrund einer Fehlanpassung der Wärmeausdehnung beschränken.

In einigen besonderen Fällen kann die Befestigung durchgeführt werden, indem das Halteteil mit UV-Licht zur Aushärtung eines Klebemittels zwischen der Trägerplatte und der Halteteilbasis bestrahlt wird, statt ein Laserlötverfahren auszuführen. Die Ausrichtung des Halteteils kann vorgenommen werden, bis die richtige Position erreicht wird. Dann wird von unterhalb der Trägerplatte das Klebemittel mit dem UV-Lichtbündel bestrahlt, wodurch es polymerisiert und dann die Befestigung erfolgt. Da das Klebemittel vor der Bestrahlung mit dem UV-Lichtbündel ziemlich flüssig ist, kann die Unterfläche des Halteteils mit dem Klebemittel in Berührung kommen, ohne daß irgendeine Spannung in das Halteteil eingebracht wird. Diese Lösung ermöglicht es, Befestigungen zu erhalten, die die verlangten Eigenschaften von Steifigkeit und Zuverlässigkeit nur dann erreichen, wenn das Klebemittel nicht durch Kriechwirkungen oder Alterungsprobleme beeinträchtigt wird.

In vielen Fällen sind die verwendeten optischen Elemente sehr teuer und des weiteren verlangt der Zusammenbau einen großen Arbeitsaufwand. Aus diesem Grund ist es, da ein Ersatzelement nicht vorgesehen werden kann, notwendig, eine alternative Lösung zu entwickeln, die einem Element ermöglicht, dessen normaler Befestigungsvorgang fehlgeschlagen hat, auf jeden Fall auf der Trägerplatte befestigt zu werden. Dies kann erreicht werden, indem auf den Bereich auf der Trägerplatte, wo die Befestigung des Elements durchgeführt werden soll, eine feste Menge an Zinnlötpaste aufgebracht wird. Das optische Element wird in bezug auf seine äußeren Bezugspunkte ausgerichtet, während seine Unterseite in die Lötpaste hineinbewegt wird. Die Tatsache, daß die Lötpaste besonders weich ist, läßt keine mechanische Beanspruchung erzeugen bzw. befürchten. Wenn das optische Element zu einem Laserstrahl vollkommen ausgerichtet ist, mit dem von unterhalb der Trägerplatte bestrahlt wird, läßt er die Zinnlötpaste schmelzen, die fest an der Trägerplatte und dem Halteteil anhaftet, wodurch gleichzeitig die verlangte Befestigung bewirkt wird.

In dem Fall, daß die Laserbestrahlung nicht die geeignetste Art ist, das Lötmittel zum Schmelzen zu bringen, können andere Lösungen in Betracht gezogen werden. Die notwendige Wärme kann tatsächlich entweder durch elektrisches Widerstandslöten oder durch magnetisches Induktionslöten eingebracht werden.

Der Erfindungsgegenstand wird im folgenden anhand von Ausführungsbeispielen unter Bezugnahme auf die beigefügten Zeichnungen näher beschrieben. Es zeigt

Fig. 1:   eine schematische Darstellung des Prinzips des Temperaturausgleichs bei einer Ausführungsform einer Halterungseinrichtung nach der Erfindung;

Fig. 2:   ein Halteteil bei einer Ausführungsform einer Halterungseinrichtung nach der Erfindung;

Fig. 3:   das Halteteil gemäß Fig. 2, das mit einem ihm zugeordneten Halterungsteil für ein Bauelement dargestellt ist, und

Fig. 4:   das Halteteil mit an ihm befestigten Halterungsteil.

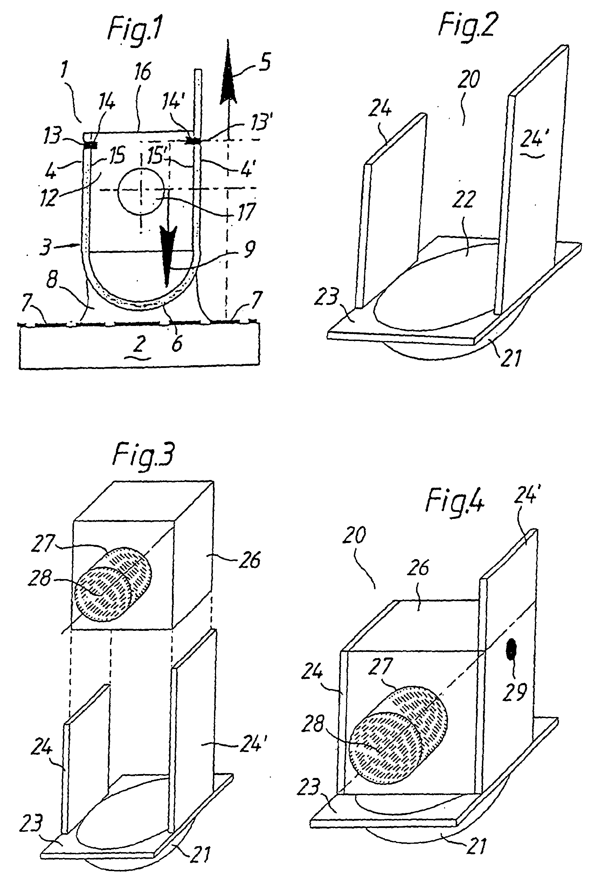

In Fig. 1 ist eine schematische Schnittdarstellung einer allgemein mit 1 bezeichneten beispielhaften Halterungseinrichtung nach der Erfindung dargestellt.

Auf einer Grundplatte 2 ist ein Halteteil 3, als ein erstes Teil, befestigt. Das Halteteil 3 ist aus einem Metallstreifen gebildet, der "U"-förmig gebogen ist. Das Halteteil 3 weist zwei "U"-Schenkel 4 und 4' auf, die durch einen gebogenen Basisabschnitt 6 verbunden sind. Der "U"-Schenkel 4' ist länger als der "U"-Schenkel 4 und kann an seiner Verlängerung von einem Roboter-Greifer bei der automatischen Montage erfaßt werden. Die Grundplatte 2 ist an ihrer Oberfläche mit Flächenbereichen 7 versehen, die für eine Lötverbindung 8 geeignet sind. Das Halteteil 3 ist mit seinem "U"-förmigen Basisabschnitt 6 an diesen Flächenbereichen 7 der Grundplatte 2 angelötet. Wenn der Metallstreifen nicht unmittelbar angelötet werden kann, so wird er vorher geeignet beschichtet.

Zwischen den "U"-Schenkeln 4 und 4' des Halteteils 3 ist ein Halterungsteil 12, als ein zweites Teil, angeordnet, das in der Form einer rechteckigen Platte dargestellt ist. Das Halterungsteil 12 ist an dem Halteteil 3 befestigt. Die Befestigung am Halteteil 3 erfolgt an einem Befestigungsort 13 im Endbereich des in der Darstellung linken "U"-Schenkels 4 und auf gleicher Höhe an einem solchen 13' an dem rechten "U"-Schenkel 4'. An dem plattenförmigen Halterungsteil 12 liegen die Befestigungsorte 14, 14' an der linken bzw. rechten Seitenkante 15, 15', jedoch ausschließlich nahe derjenigen Endkante 16, die weiter von dem Basisabschnitt 6 entfernt ist. Mithin ist das plattenförmige Halterungsteil 12 nur einseitig oder auslegerartig im Bereich seiner Endkante 16 befestigt. Abgesehen von dieser Befestigung zwischen Halteteil 3 und Halterungsteil 12 gibt es zwischen ihnen keine weitere starre Verbindung. Die Verbindung von Halteteil 3 und Halterungsteil 12 kann beispielsweise durch Punktschweißung erfolgen.

Das Halterungsteil 12 ist mit einer mittigen Öffnung 17 ausgebildet, in der ein nicht gezeigtes Bauteil gehalten wird.

Wenn die gezeigte Halterungseinrichtung einer Temperaturänderung - z.B. einer Temperaturerhöhung - ausgesetzt wird, so dehnen sich die beiden "U"-Schenkel 4, 4', die durch den Basisabschnitt 6 fest mit der Grundplatte 2 verbunden sind, aus, wobei hier nur die Ausdehnung in ihrer Längsrichtung als für die Lage des Bauteils relevant betrachtet wird. Der Abstand zwischen den Befestigungsorten 13, 13' an den "U"-Schenkeln 4, 4' einerseits sowie dem Basisabschnitt 6 andererseits nimmt durch die Wärmeausdehnung zu, vergleiche den nach oben gerichteten Pfeil 5. Gleichzeitig dehnt sich auch das plattenförmige Halterungsteil 12 aus, nämlich in Richtung zu dem Basisabschnitt 6, da es in seinem oberen Abschnitt an den genannten Befestigungsorten 14, 14' fest mit den U-Schenkeln 4, 4' verbunden ist; vergleiche den nach unten gerichteten Pfeil 9.

Wenn die Längenänderung der "U"-Schenkel 4, 4' zwischen den genannten Befestigungsorten 13, 13' und dem Basisabschnitt 6 ebenso groß gemacht wird, wie die Längenänderung des plattenförmigen Halterungsteils 12 zwischen dessen Befestigungsorten 14, 14' und dem Mittelpunkt der Öffnung 17, dann bleibt der Abstand zwischen diesem Mittelpunkt und dem Basisabschnitt 6 - unabhängig von Temperaturänderungen - konstant.

Fig. 2 bis 4 zeigen Phasen des Zusammenbaus einer weiteren Ausführungsform einer Halterungseinrichtung nach der Erfindung.

Fig. 2 zeigt ein Halteteil 20, das aus einem kugelschalenförmigen Basisteil 21 geformt ist, das einen eine Öffnung 22 des Basisteils 21 umgebenden Randbereich 23 aufweist. Der Außenumfang des Randbereiches 23 ist beispielsweise quadratisch. Auf zwei gegenüberstehenden Seiten des Randbereiches 23 sind zwei streifenförmige aufrechte Lappen 24, 24' vorgesehen. Wie in Fig. 1 der rechte "U"-Schenkel, ist auch hier der rechte Lappen 24' etwas länger als der linke Lappen 24. Das Halteteil 20 ist vorzugsweise einstückig 21,23,24,24' ausgebildet.

Fig. 3 zeigt ein parallelepiped-förmiges Halterungsteil 26 mit einer mittigen Durchgangsöffnung 27. In dieser ist ein schematisch dargestelltes optisches Element 28 angeordnet. Es ist zu erkennen, daß das Halterungsteil 26 so ausgebildet ist, daß es zwischen die beiden Lappen 24, 24' eingefügt werden kann.

Fig. 4 zeigt das von dem Halteteil 20 aufgenommene Halterungsteil 26. Dieses ist mit dem Halteteil 20 durch zwei einander gegenüberliegende Punktschweißungen verbunden, von denen nur eine 29 erkennbar ist. Im Fall einer Temperaturänderung können sich die beiden streifenförmigen Lappen 24, 24' relativ zu dem Basisteil 21 ausdehnen bzw. zusammenziehen. Das gleiche gilt für das Halterungsteil 26, wobei aber die Längenänderung gegenläufig zu derjenigen der Lappen 24, 24' ist. Bei entsprechender Bemaßung der Teile und Auswahl der Werkstoffe hinsichtlich der Wärmeausdehnungskoeffizienten kann der Abstand zwischen der Mitte der Durchgangsöffnung 27 und dem Basisteil 21 unabhängig von der Temperatur in hohem Maße konstant gehalten werden.

**Bezugszeichenliste**

| | |
|---|---|
| 1 | - Halterungseinrichtung |
| 2 | - Grundplatte |
| 3,20 | - Halteteil ("erstes Teil") |
| 4 | - "U"-Schenkel |
| 4' | - (längerer) "U"-Schenkel |
| 5 | - Pfeil, nach oben gerichte |
| 6 | - (gebogener) Basisabschnitt |
| 7 | - Flächenbereiche auf (2), geeignet für (8) |
| 8 | - Lötverbindung |
| 9 | - Pfeil, nach unten gerichtet |
| 12 | - Halterungsteil ("zweites Teil") |
| 13 | - Befestigungsort an (4) |
| 13' | - Befestigungsort an (4') |
| 14,14' | - Befestigungsorte an (15,15') |
| 15,15' | - Seitenkanten von (12) |
| 16 | - Endkante von (12) |
| 17 | - mittige Öffnung von (12) |
| 21 | - (kugelschalenförmiges) Basisteil |
| 22 | - Öffnung von (21) |
| 23 | - Randbereich von (21) |
| 24 | - streifenförmiger aufrechter Lappen |
| 24' | - streifenförmiger aufrechter (längerer) Lappen |
| 26 | - parallelepided-förmiges Halterungsteil ("zweites Teil") |
| 27 | - mittige Durchgangsöffnung |
| 28 | - Bauteil; optisches Element |
| 29 | - Punktschweißung ("Befestigungsort") |

**Patentansprüche**

1. Einrichtung zur thermostabilen Halterung eines miniaturisierten, insbesondere elektronischen oder optischen, Bauteils, mit einem ersten und einem zweiten Teil, wobei das zweite Teil an dem ersten Teil an zwei Befestigungsorten befestigt ist und das Bauteil hält, **dadurch gekennzeichnet, dass** das erste Teil (20) mit einem Basisteil (21) mit einer konvexen Fläche, insbesondere in Form einer Kugelschale, ausgebildet ist, und an dem Basisteil (21) zwei Lappen (24, 24') aufweist, zwischen denen das zweite Teil (26) angeordnet ist und an denen es in zwei auf unterschiedlichen Seiten des zweiten Teils befindlichen Punkten an den Befestigungsorten (13,13';29) befestigt ist, und einerseits die Lage des Halterungsorts (17;27) des Bauteils (28) an dem zweiten Teil (12;26) in Bezug auf den Befestigungsort (13;13';29) zwischen dem ersten (3;20) und zweiten (12;26) Teil, und andererseits jeweils der Werkstoff für das erste und zweite Teil (3;20 bzw. 12;26) mit einem spezifischen Wärmeausdehungskoeffizienten $\alpha_1$ bzw. $\alpha_2$ ausgewählt wird derart, dass der Einfluss der Wärmeausdehnung des ersten und zweiten Teils (3;20 bzw. 12;26) auf die Lage des Halterungsorts (17;27) des Bauteils (28) in Bezug auf einem Bezugspunkt auf dem Basisteil (21) zumindest teilweise aufgehoben wird.

2. Einrichtung zur Halterung eines miniaturisierten Bauteils, nach Anspruch 1, **dadurch gekennzeichnet, dass** einer der beiden Lappen (24, 24') mit einer gegenüber dem anderen Lappen grösseren Länge ausgebildet ist, so dass das erste Teil (20) an dem längeren Lappen durch eine Transport- und Positioniervorrichtung aufgenommen, bewegt und positioniert werden kann.

3. Einrichtung nach Anspruch 1 oder 2, **dadurch gekennzeichnet, dass** das erste Teil (20) einstückig ausgebildet ist.

4. Einrichtung nach einem der vorhergehenden Ansprüche, **dadurch gekennzeichnet, dass** das erste und/oder zweite Teil (3;20 bzw. 12;26) aus einem Metall, einem Keramik-Material oder einer Metall-Legierung hergestellt ist.

**5.** Einrichtung nach Anspruch 4, **dadurch gekennzeichnet, dass** das Metall, das Keramik-Material oder die Metall-Legierung ausgewählt ist aus: $AL_2O_3$, Cu, CuBe-Legierung, Invar.

**Claims**

**1.** Device for supporting, in a thermally stable manner, a miniaturized, in particular electronic or optical, component, comprising a first and a second part, the second part being fastened to the first part at two fastening locations and supporting the component, **characterized in that** the first part (20) is formed with a base part (21) having a convex surface, in particular in the shape of a spherical shell, and has, on the base part (21), two flaps (24, 24') between which the second part (26) is arranged and to which it is fastened at the fastening locations (13, 13'; 29) in two points on different sides of the second part, and, on the one hand, the position of the support location (17; 27) of the component (28) on the second part (12; 26) in relation to the fastening location (13; 13'; 29) between the first (3; 20) and second (12; 26) part and, on the other hand, in each case the material for the first and second part (3; 20 and 12; 26, respectively) having a specific coefficient of thermal expansion $\alpha_1$ and $\alpha_2$, respectively, are chosen in such a way that the influence of the thermal expansion of the first and second part (3; 20 and 12; 26, respectively) on the position of the support location (17; 27) of the component (28) in relation to a reference point on the base part (21) is at least partly eliminated).

**2.** Device for supporting a miniaturized component, according to Claim 1, **characterized in that** one of the two flaps (24, 24') is formed with a length larger than that of the other flap, so that the first part (20) can be picked up by the longer flap by means of a transport and positioning device and can be moved and positioned.

**3.** Device according to Claim 1 or 2, **characterized in that** the first part (20) is formed in one piece.

**4.** Device according to any of the preceding Claims, **characterized in that** the first and/or the second part (3; 20 and 12; 26, respectively) is produced from metal, a ceramic material or a metal alloy.

**5.** Device according to Claim 4, **characterized in that** the metal, the ceramic material or the metal alloy is selected from: $Al_2O_3$, Cu, CuBe alloy, invar.

**Revendications**

**1.** Dispositif pour la fixation stable thermiquement d'un composant miniaturisé, en particulier électronique ou optique, avec une première et une deuxième partie, la deuxième partie étant fixée sur la première partie, en deux sites de fixation, et maintient le composant, **caractérisé en ce que** la première partie (20) est réalisée avec une partie de base (21) à surface convexe, en particulier ayant la forme d'une coque sphérique, et présente sur la partie de base (21) deux languettes (24, 24'), entre lesquelles est disposée la deuxième partie (26) et sur lesquelles elle est fixée en deux points, se trouvant, sur des faces différentes de la deuxième partie, sur les sites de fixation (13, 13'; 29) et, d'une part, la position du site de fixation (17; 27) du composant (28) sur la deuxième partie (12; 26) par rapport au site de fixation (13, 13'; 29) entre la première (3; 20) et la deuxième (12; 26) parties et, d'autre part, chaque fois le matériau pour la première et la deuxième parties (3; 20 ou 12; 26) ayant un coefficient de dilatation thermique $\alpha_1$ ou $\alpha_2$ spécifique, sont sélectionnés de manière que l'influence de la dilatation thermique de la première et la deuxième partie (3; 20 ou 12; 26) sur la position du site de fixation (17; 27) du composant (28) par rapport à un point de référence situé sur la partie de base (21) soit au moins partiellement annulée.

**2.** Dispositif de fixation d'un composant miniaturisé, selon la revendication 1, **caractérisé en ce que** l'une des deux languettes (24, 24') est réalisée avec une longueur supérieure à celle de l'autre languette, de sorte que la première partie (20) puisse être supportée, déplacée et positionnée sur la languette la plus longue, au moyen d'un dispositif de transport et de positionnement.

**3.** Dispositif selon la revendication 1 ou 2, **caractérisé en ce que** la première partie (20) est réalisée en une seule pièce.

**4.** Dispositif selon l'une des revendications précédentes, **caractérisé en ce que** la première et/ou la deuxième partie (3;20 ou 12:26) est/sont fabriquée(s) en un métal, un matériau céramique ou bien un alliage métallique.

**5.** Dispositif selon la revendication 4, **caractérisé en ce que** le métal, le matériau céramique ou l'alliage métallique est sélectionné parmi : $Al_2O_3$, Cu, un alliage CuBe, l'Invar.

## Fig.1

## Fig.2

## Fig.3

## Fig.4